Europäisches Patentamt

European Patent Office

Office européen des brevets

(19)

(11) Veröffentlichungsnummer: **0 399 476**
**A2**

## EUROPÄISCHE PATENTANMELDUNG

(21) Anmeldenummer: 90109724.6

(22) Anmeldetag: 22.05.90

(51) Int. Cl.⁵: **H01L 29/743, H01L 29/08, H01L 29/60**

(30) Priorität: 26.05.89 DE 3917100

(43) Veröffentlichungstag der Anmeldung:
28.11.90 Patentblatt 90/48

(84) Benannte Vertragsstaaten:
CH DE FR GB LI SE

(71) Anmelder: **EUPEC Europäische Gesellschaft für Leistungshalbleiter mbH & Co. KG**
**Max-Planck-Strasse 5**
**D-4788 Warstein/Belecke(DE)**

(72) Erfinder: **Schoof, Holger, Dr.**
**Hukensiel 1**
**D-4784 Rüthen(DE)**
Erfinder: **Sommer, Karl Heinz, Dr.**
**Goethestrasse 12**
**D-4788 Warstein(DE)**

(74) Vertreter: **Fuchs, Franz-Josef, Dr.-Ing. et al**
**Postfach 22 13 17**
**D-8000 München 22(DE)**

(54) Thyristor.

(57) Thyristor aus einem Hauptthyristor und einem Hilfsthyristor, bei dem zur Verbesserung der dynamischen Eigenschaften der Rand des von der Steuerbasiszone (2) und der Hilfsemitterzone (8) gebildeten pn-Übergangs im oberflächennahen Bereich der Halbleiterscheibe auf der der Steuerlektrode (7) gegenüberliegenden Seite eine von der Kreisform abweichende Struktur aufweist.

FIG 1

EP 0 399 476 A2

Die Erfindung betrifft einen Thyristor mit einer Halbleiterscheibe aus mindestens vier Zonen abwechselnd entgegengesetzten Leitungstyps, mit einer zentral angeordneten, die Steuerbasiszone kontaktierenden Steuerelektrode, einer die Steuerelektrode mit Abstand umgebende Hilfsemitterzone mit einem Hilfskathodenkontakt und mit einer die Hilfsemitterzone mit Abstand umgebende Hauptemitterzone mit einem Hauptkathodenkontakt, wobei die Hilfsemitterzone unter Mitwirkung der weiteren Zonen des Hauptthyristors einen Hilfsthyristor zur Zündverstärkung bildet und mit der Steuerbasiszone über den Hilfskathodenkontakt in leitender Verbindung steht.

Ein derartiger Thyristor mit einem sogenannten Amplifying Gate ist z. B. aus "Thyristoren mit innerer Zündverstärkung", Teil 1, J. Burkscher, VDE-Tagung in Aachen, 1971, bekannt. Die Thyristorstruktur besteht aus einem Hauptthyristor und einem Hilfs- bzw. Pilotthyristor, dessen kathodenseitige Emitterzone mit der Steuerbasiszone des Hauptthyristors in leitender Verbindung steht. Bei diesem Thyristortyp wird eine Zündverstärkung dadurch erzielt, daß durch den in die Steuerelektrode eingespeisten Steuerstrom zunächst der Hilfsthyristor gezündet wird, dessen Laststrom in die Steuerbasiszone des Hauptthyristors fließt und diesen durchzündet. Infolge der Zündverstärkung werden die dynamischen Eigenschaften des Thyristors, insbesondere sein Einschaltverhalten, wesentlich verbessert.

Das Amplifying Gate läßt sich dann besonders wirkungsvoll einsetzen, wenn der Emitter des Hauptthyristors eine verzweigte Struktur aufweist (DE-PS 20 13 742). In besonderer Weise lassen sich noch bessere dynamische Eigenschaften erzielen, wenn der Hauptthyristor als asymmetrischer Thyristor ausgebildet ist. Der Unterschied zu einem normalen Thyristor mit einer pnpn-Struktur besteht darin, daß die n-leitende Hauptbasiszone aus zwei Schichten zusammengesetzt ist, nämlich einer schwach enddotierten Zone und einer an die benachbarte Steuerbasiszone angrenzenden, höher n-dotierten Zone. Für viele Anwendungszwecke reichen jedoch die dynamischen Eigenschaften der bekannten Thyristoren nicht aus. Insbesondere wird eine Heraufsetzung der Betriebsfrequenz angestrebt.

Der Erfindung liegt die Aufgabe zugrunde, die dynamischen Eigenschaften eines Thyristors mit Amplifying Gate, insbesondere eines asymmetrischen Thyristors mit verzweigtem Hauptthyristor, zu verbessern und die Einschaltverluste weiter zu verringern.

Diese Aufgabe wird gemäß der Erfindung dadurch gelöst, daß der Rand des von der Steuerbasiszone und der Hilfsemitterzone gebildeten pn-Übergangs im oberflächennahen Bereich der Halbleiterscheibe auf der der Steuerelektrode gegenüberliegenden Seite eine von der Kreisform abweichende Struktur aufweist.

Die Abweichung von der Kreisform soll derart gewählt werden, daß eine möglichst große Randlänge des zwischen der Emitter- und der Steuerbasiszone des Hauptthyristors gebildeten pn-Übergangs bei kleiner Fläche des Hilfsemitters entsteht. Durch eine Vergrößerung dieser Randlänge lassen sich nicht nur die Einschaltverluste verringern, sondern insbesondere auch die Schaltfrequenz des Thyristors erhöhen. Dies gilt in besonderem Maße, wenn der Hauptthyristor als asymmetrischer Thyristor mit verzweigter Hauptemitterstruktur ausgebildet ist. In diesem Fall läßt sich eine Schaltfrequenz von mehr als 20 kHz erzielen.

Weiterbildungen der Erfindung sind den Unteransprüchen zu entnehmen.

Das Wesen der Erfindung soll anhand der Zeichnungen näher erläutert werden. Es zeigen:

Fig. 1 die Draufsicht eines Thyristors mit einer mäanderförmigen Strukturierung des Randbereichs der Hilfsemitterzone;

Fig. 2 einen Querschnitt des Thyristors nach Fig. 1 und

Fig. 3 einen Thyristor, bei dem zusätzlich der Rand der Steuerelektrode mäanderförmig ausgebildet ist.

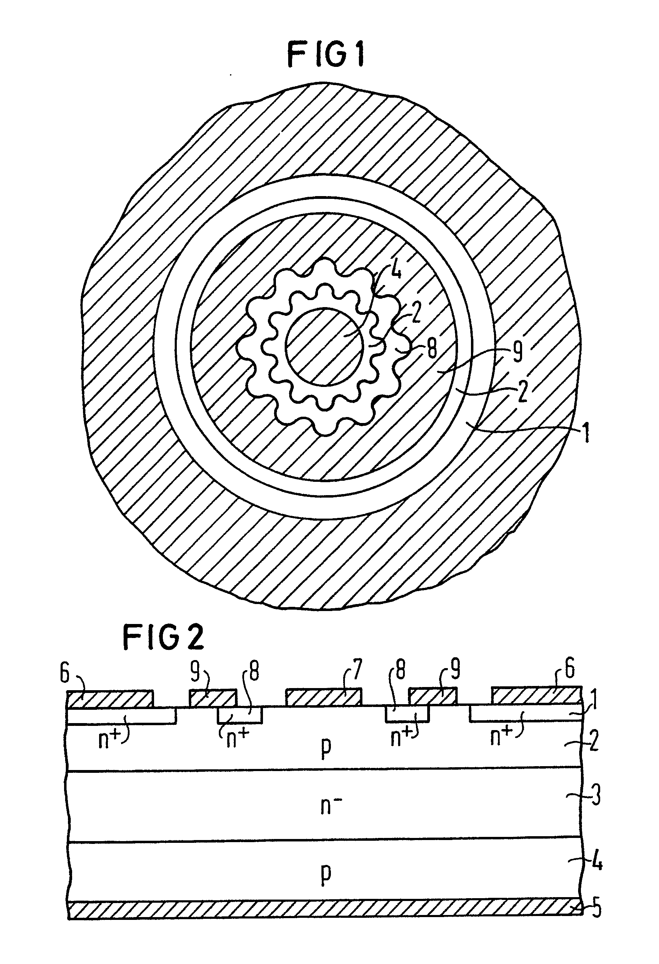

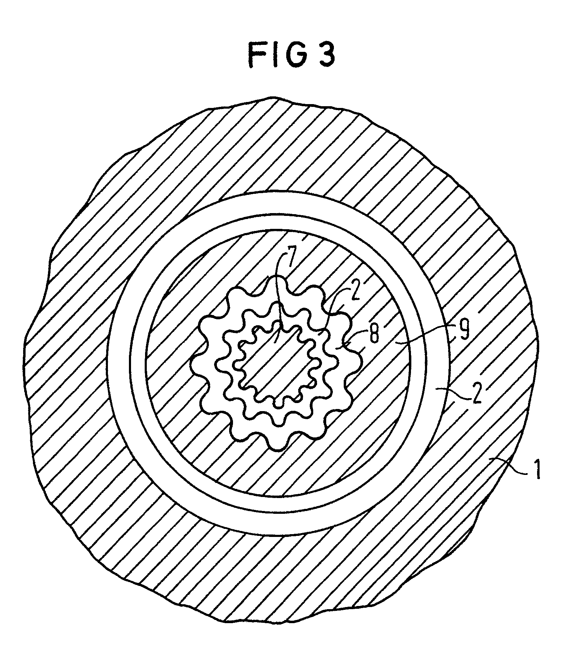

In dem Ausführungsbeispiel nach Fig. 1 und 2 besteht der Hauptthyristor aus der kathodenseitigen Emitterzone 1, der Steuerbasiszone 2, der Hauptbasiszone 3 und der anodenseitigen Emitterzone 4. Die anodenseitige Emitterzone ist mit einem Anodenkontakt 5 und die kathodenseitige Emitterzone mit einem Kathodenkontakt 6 versehen. Zwischen der Steuerelektrode 7 und dem Hauptkathodenkontakt 6 bzw. der Emitterzone 1 ist der Hilfsthyristor angeordnet, wobei die räumliche Ausdehnung des Hilfsthyristors im wesentlichen durch die Ausdehnung der Hilfsemitterzone 8 bestimmt wird und die übrigen Zonen des Hilfsthyristors in bekannter Weise aus Teilzonen des Hauptthyristors gebildet werden. Die Hilfsemitterzone 8 und der benachbarte Bereich der Steuerbasiszone 2 des Hauptthyristors sind mittels eines Hilfskathodenkontaktes 9 leitend miteinander verbunden. Durch Einspeisung eines Steuerstroms in den Steuerkontakt 7 wird zunächst das Hilfsthyristorsystem gezündet und der Laststrom des Hilfsthyristors über den Hilfskathodenkontakt 9 in die Steuerbasiszone 1 des Hauptthyristors geleitet und dieser auf diese Weise gezündet.

Der Rand des pn-Übergangs zwischen der Steuerbasiszone 2 und der Hilfsemitterzone 8 ist nicht mehr kreisförmig, sondern im Ausführungsbeispiel mäanderförmig ausgebildet. Auf diese Weise wird die Randlänge ohne zusätzlichen Platzbedarf wesentlich vergrößert, wodurch sich die Einschaltverluste verringern lassen. Ferner ist der Hilfskathodenkontakt 9 der Hilfsemitterzone 8 im Bereich dieser Zone mäanderförmig ausgebildet.

Eine Verbesserung der dynamischen Eigenschaften läßt sich noch dadurch erreichen, daß der Hauptthyristor eine verzweigte Emitterstruktur aufweist und gegebenenfalls auch noch als asymmetrischer Thyristor ausgebildet ist.

Bei dem Ausführungsbeispiel nach Fig. 3 ist zusätzlich zu der mäanderförmigen Ausbildung des pn-Übergangs zwischen der Steuerbasiszone 2 und der Hilfsemitterzone 1 sowie des Hilfsemitterkontaktes 9 zusätzlich der Steuerelektrodenkontakt 7 mäanderförmig ausgebildet derart, daß die beiden mäanderförmigen Strukturen ineinander greifen. Durch diese Ausbildung des Steuerelektrodenkontaktes läßt sich eine weitere Verbesserung der dynamischen Eigenschaften erzielen. Auch diese Ausführungsform läßt sich besonders günstig bei einem Thyristor mit verzweigtem Hauptemitter und gleichzeitiger Ausbildung als asymmetrischer Thyristor einsetzen.

## Ansprüche

1. Thyristor aus einem Hauptthyristor und einem Hilfsthyristor mit einer Halbleiterscheibe aus mindestens vier Zonen abwechselnd entgegengesetzten Leitungstyps, mit einer zentral angeordneten, die Steuerbasiszone kontaktierenden Steuerelektrode, einer die Steuerelektrode mit Abstand umgebende Hilfsemitterzone und mit einer die Hilfsemitterzone mit Abstand umgebenden Hauptemitterzone mit einem Hauptkathodenkontakt, wobei die Hilfsemitterzone unter Mitwirkung der weiteren Zonen des Hauptthyristors den Hilfsthyristor zur Zündverstärkung bildet und mit der Steuerbasiszone über einen Hilfskathodenkontakt in leitender Verbindung steht,
dadurch gekennzeichnet,
daß der Rand des von der Steuerbasiszone (2) und der Hilfsemitterzone (8) gebildeten pn-Übergangs im oberflächennahen Bereich der Halbleiterscheibe auf der der Steuerelektrode (7) gegenüberliegenden Seite eine von der Kreisform abweichende Struktur aufweist.

2. Thyristor nach Anspruch 1,
dadurch gekennzeichnet, daß das Verhältnis der Randlänge des von der Steuerbasiszone (2) und der Hilfsemitterzone (8) gebildeten pn-Übergangs im oberflächennahen Bereich der Halbleiterscheibe auf der der Steuerelektrode (7) gegenüberliegenden Seite zur Fläche der Hilfsemitterzone (8) möglichst groß ist.

3. Thyristor nach Anspruch 2,
dadurch gekennzeichnet, daß das Verhältnis der Randlänge des zwischen der Emitter- und der Steuerbasiszone des Hauptthyristors gebildeten pn-Übergangs zu der Fläche der Hilfsemitterzone größer als 10 ist.

4. Thyristor nach einem der Ansprüche 1 bis 3, dadurch gekennzeichnet, daß der Rand zwischen der Steuerbasiszone (2) und der Hilfsemitterzone (8) gebildeten pn-Übergangs mäanderförmig ausgebildet ist.

5. Thyristor nach einem der Ansprüche 1 bis 4, dadurch gekennzeichnet, daß der Hilfskathodenkontakt (9) der Hilfsemitterzone (8) im Bereich dieser Zone eine von der Kreisform abweichende Struktur aufweist.

6. Thyristor nach Anspruch 5,
dadurch gekennzeichnet, daß der Rand des Hilfskathodenkontakts (9) mäanderförmig ausgebildet ist.

7. Thyristor nach Anspruch 4 und 6,
dadurch gekennzeichnet, daß die mäanderförmigen Strukturen des Hilfskathodenkontakts (9) und des pn-Übergangs zwischen der Steuerbasiszone (2) und der Hilfsemitterzone (8) zueinander ineinandergreifend angeordnet sind.

8. Thyristor nach einem der Ansprüche 4 bis 7, dadurch gekennzeichnet, daß die Steuerelektrode (7) ebenfalls mäanderförmig ausgebildet ist.

9. Thyristor nach Anspruch 8,
dadurch gekennzeichnet, daß der Abstand zwischen der Steuerelektrode (7) und dem Rand des zwischen der Steuerbasiszone (2) und der Hilfsemitterzone (8) gebildeten pn-Übergangs überall etwa gleich groß ist.

10. Thyristor nach einem der Ansprüche 1 bis 9,
dadurch gekennzeichnet, daß der Thyristor als asymmetrischer Thyristor ausgebildet ist, bei dem die Hauptbasiszone aus einer schwachdotierten, an die Steuerbasiszone angrenzenden Zone und einer höherdotierten Zone gleichen Leitungstyps besteht.

11. Thyristor nach einem der Ansprüche 1 bis 10,
dadurch gekennzeichnet, daß die Hauptemitterzone eine verzweigte Struktur aufweist.

# FIG 1

# FIG 2

# FIG 3